# EUROPEAN PATENT APPLICATION

(11) **EP 1 881 525 A1**
(43) Date of publication of application: **23.01.2008**
(21) Application number: 06745893.5
(22) Date of filing: 28.04.2006
(51) Int. Cl.: H01L 21/3065, H01L 21/205

(54) **ETCHING METHOD, METHOD FOR PRODUCING DIELECTRIC FILM OF LOW DIELECTRIC CONSTANT, METHOD FOR PRODUCING POROUS MEMBER, ETCHING SYSTEM AND THIN FILM FORMING EQUIPMENT**

(30) Priority: 28.04.2005 JP 2005133266
(71) Applicant: PhyzChemix Corporation, Minato-ku Tokyo 107-0052 (JP)
(72) Inventor: SAKAMOTO, Hitoshi MITSUBISHI HEAVY INDUSTRIES, LTD, Yokohama-shi, Kanagawa 2368515 (JP); KOBAYASHI, Chikako, HITEC Co., Ltd.,, Yokohama-shi, Kanagawa 2368515 (JP)
(74) Representative: HOFFMANN EITLE
(86) International application number: PCT/JP2006/309034
(87) International publication number: WO 2006/118271

(57) **Abstract**

To provide an etching method employing a novel CVD system and an etching apparatus applicable to the method.

In the etching method, performed are an adsorption step of employing halogen radicals generated from a halogen through formation of a plasma thereof, and a precursor 24 formed from the halogen and a noble metal component generated through etching of a noble metal member 11 by the halogen radicals, wherein crystal nuclei of the precursor 24 are caused to be adsorbed on a substrate 3; and an etching step of anisotropically etching, in a thickness direction by the halogen radicals, a portion of the substrate 3 on which the crystal nuclei have been adsorbed.

## Description

### Technical Field

The present invention relates to a novel etching method; and to an etching apparatus and thin film formation apparatus which can be employed for the method.
The present invention also relates to a method for producing a dielectric film of low dielectric constant; and to a method for producing a porous member, each of the methods employing the novel etching method.

### Background Art

Currently known techniques for the production of, for example, semiconductors include film formation by means of a plasma CVD (chemical vapor deposition) apparatus. In a plasma CVD apparatus, a gas of an organometallic complex, etc., serving as a film material, is introduced into a chamber; a plasma of the gas is formed by means of a high-frequency wave radiated from a high-frequency antenna; and a film (e.g., a metal thin film) is formed through chemical reaction accelerated on the surface of a substrate by excited active atoms contained in the plasma.

In connection with this, the present inventors previously developed a film formation method and a plasma CVD apparatus (see, for example, the below-described Patent Document 1), in which a member to be etched, the member containing a metal component which forms a halide of high vapor pressure for film formation, is placed in a chamber; a plasma of a halogen gas is formed; and the member is etched by the resultant halogen radicals, to thereby yield a precursor (i.e., a halide of the metal component), and to form, on a substrate, a film of only the metal component of the precursor (hereinafter the apparatus may be referred to as a "new-system plasma CVD apparatus").

Patent Document 1: Japanese Patent Application Laid-Open (kokai) No. 2003-147534

In the aforementioned new-system plasma CVD apparatus, the temperature of a substrate is controlled so as to be lower than that of a target serving as a source of a metal employed for film formation, and a film of the metal is formed on the substrate. In the case where, for example, a metal M is employed as a target, and Cl₂ is employed as a halogen gas, when the temperature of the target is controlled to be high (e.g., 300°C to 700°C), and the temperature of a substrate is controlled to be low (e.g., about 200°C), a thin film of the metal (M) can be formed on the substrate. Conceivably, this film formation proceeds through the following reactions.

(1) Plasma-induced dissociation: Cl₂ → 2Cl*
(2) Etching reaction: M + Cl* → MCl (g)
(3) Adsorption onto substrate: MCl (g) → MCl (ad)
(4) Film formation reaction: MCl (ad) + C1* → M + Cl₂ ↑
   In these formulas, the symbols Cl*, (g), and (ad) represent C1 radical, gaseous state, and adsorbed state, respectively.

In the aforementioned new-system CVD apparatus, when the ratio by amount of MCl to Cl* is appropriately maintained, film formation reaction proceeds appropriately. Specifically, when film formation conditions (e.g., Cl₂ gas flow rate, pressure, power, the temperatures of a substrate and a target, and the distance between the substrate and the target) are appropriately determined, the ratio by amount of MCl to Cl* can be maintained almost constant, and the metal (M) is deposited on the substrate without reduction of film formation rate and without causing excessive etching by Cl*.

The present inventors have found that such a new-system CVD technique can be applied not only to thin film formation, but also to a variety of processing.

### Disclosure of the Invention

### Problems to be Solved by the Invention

In view of the foregoing, an object of the present invention is to provide an etching method employing the aforementioned new-system CVD technique. Another object of the present invention is to provide an etching apparatus and thin film formation apparatus which can be applied to the etching method.

### Means for Solving the Problems

The present inventors have found that an application of the aforementioned new-system CVD technique employing a predetermined target realizes very fine anisotropic etching, and have accomplished the present invention on the basis of this finding. The present inventors have also found that employment of this etching technique realizes formation of micropores of high aspect ratio, formation of a low-dielectric-constant member having a predetermined dielectric constant, and production of a porous material having a predetermined porosity.

In a conventional semiconductor process, formation of micropores (e.g., through-holes) requires formation of a resist pattern and etching. Although formation of such a resist pattern requires an intricate photoresist process, such a problem can be solved by application of the aforementioned CVD technique.

An ultra large scale integrated circuit (ULSI) includes a transistor, a plurality of wiring layers, and an interlayer dielectric film. As has been known, such an interlayer dielectric film is desirable to have a low dielectric constant for attaining high speed and low loss. Known methods for forming such a film of low dielectric constant include a method for forming a CHₓ-bubble-containing SiO₂ film of low density through MOCVD employing, as raw material gases, an organic silane gas (e.g., monomethylsilane (SiH₃CH₃) or dimethylsilane [(CH₃)₂SiH₂)] and N₂O or O₂; a method for forming an SiO₂ film holding He bubbles, in which an SiO₂ film is formed from SiH₄ and O₂ through CVD in the presence of He; a method for forming a film from a material of low dielectric constant (e.g., boron nitride (BN)); and a film formation method including application and firing of an organic film.

However, the method in which bubbles are caused to be contained in a film poses a problem in that the method encounters difficulty in controlling the amount of bubbles and in attaining a predetermined dielectric constant. The method employing boron nitride poses a problem in that a predetermined crystal system is required. In addition, employment of an organic film raises a problem in terms of durability. However, these problems can be solved by application of the aforementioned etching technique.

Conventionally, a thin-film filter made of porous ceramic material has been employed as, for example, a gas filter or a catalyst filter. Such a ceramic filter poses a problem in that it is difficult to recycle due to adsorption of the ceramic *per se.* However, a porous material that does not raise such a problem can be provided through application of the aforementioned etching technique.

According to a first mode of the present invention, which has been accomplished on the basis of the aforementioned findings, there is provided an etching method characterized by comprising an adsorption step of employing halogen radicals generated from a halogen through formation of a plasma thereof, and a precursor formed from the halogen and a noble metal component generated through etching of a noble metal member by the halogen radicals, wherein crystal nuclei of the precursor are caused to be adsorbed on a member to be etched (hereinafter may be referred to as an "etching member"); and an etching step of anisotropically etching, in a thickness direction by the halogen radicals, a portion of the etching member on which the crystal nuclei have been adsorbed.

According to the first mode, for example, micropores of high aspect ratio can be formed through the adsorption step of causing crystal nuclei of the precursor to be adsorbed on an etching member, and through the etching step of anisotropically etching, in a thickness direction by the halogen radicals, a portion of the etching member on which the crystal nuclei have been adsorbed.

A second mode of the present invention is drawn to a specific embodiment of the etching method according to the first mode, wherein the flux ratio of the precursor to the halogen radicals is changed in the adsorption step and the etching step so that, in the adsorption step, the flux of the precursor is controlled to be greater than that of the halogen radicals, whereas in the etching step, the flux of the halogen radicals is controlled to be greater than that of the precursor.

According to the second mode, since, in the adsorption step, the flux of the precursor is controlled to be greater than that of the halogen radicals, the crystal nuclei of the precursor can be efficiently adsorbed on the etching member. Meanwhile, since, in the etching step, the flux of the halogen radicals is controlled to be greater than that of the precursor, a portion of the etching member on which the crystal nuclei have been adsorbed can be anisotropically etched efficiently in a thickness direction by the halogen radicals.

A third mode of the present invention is drawn to a specific embodiment of the etching method according to the first or second mode, wherein the temperature of the etching member is changed in the adsorption step and the etching step so that, in the adsorption step, the temperature of the etching member is controlled to such a temperature that the crystal nuclei are adsorbed on the etching member, whereas in the etching step, the temperature of the etching member is controlled to be higher than that in the adsorption step so that etching by the halogen radicals is promoted without adsorption of the crystal nuclei.

According to the third mode, since the temperature of the etching member is changed, in the adsorption step, the crystal nuclei are efficiently adsorbed on the member, and in the etching step, etching is promoted without adsorption of the crystal nuclei.

A fourth mode of the present invention is drawn to a specific embodiment of the etching method according to any of the first to third modes, wherein, when the noble metal member is etched by the halogen radicals, the temperature of the noble metal member is changed to a higher temperature for increasing the size of the crystal nuclei, or the temperature of the noble metal member is changed to a lower temperature for reducing the size of the crystal nuclei.

According to the fourth mode, since the size of the crystal nuclei can be changed by controlling the temperature of the noble metal member, the diameter of pores formed through etching can be changed.

A fifth mode of the present invention is drawn to a specific embodiment of the etching method according to any of the first to fourth modes, wherein the noble metal is iridium (Ir) or platinum (Pt).

According to the fifth mode, crystal nuclei of a precursor formed from the halogen and Ir or Pt can be adsorbed on the etching member, and a region of the member on which the crystal nuclei have been adsorbed can be etched.

A sixth mode of the present invention is drawn to a specific embodiment of the etching method according to any of the first to fifth modes, wherein the crystal nuclei are caused to be discretely adsorbed on a predetermined etching region of the etching member.

According to the sixth mode, since the crystal nuclei are caused to be discretely adsorbed on a predetermined etching region of the etching member, for example, micropores of high aspect ratio can be discretely formed within the etching region.

A seventh mode of the present invention is drawn to a specific embodiment of the etching method according to the sixth mode, wherein the outermost surface of the etching region of the etching member readily adsorbs the crystal nuclei, as compared with the outermost surface of a region other than the etching region.

According to the seventh mode, since the crystal nuclei are relatively readily adsorbed on the etching region, for example, micropores of high aspect ratio can be formed selectively within the etching region.

An eighth mode of the present invention is drawn to a specific embodiment of the etching method according to any of the first to seventh modes, wherein the crystal nuclei are caused to be adsorbed selectively on a portion which has been irradiated with an excitation beam.

According to the eighth mode, since the crystal nuclei are caused to be adsorbed selectively on a portion irradiated with an excitation beam, for example, micropores of high aspect ratio can be formed in a predetermined location.

A ninth mode of the present invention is drawn to a specific embodiment of the etching method according to any of the first to eighth modes, wherein a surface of the etching member is roughened through anisotropic etching.

According to the ninth mode, since the surface of the etching member is roughened through anisotropic etching, improvement can be achieved in terms of, for example, adhesion between the etching member and a film which is formed thereon.

A tenth mode of the present invention is drawn to a specific embodiment of the etching method according to any of the first to eighth modes, wherein the etching member is a thin film formed on the outermost surface of a substrate, and at least one through-hole which penetrates through the thin film is formed through anisotropic etching.

According to the tenth mode, a through-hole which penetrates through the thin film can be formed through anisotropic etching.

According to an eleventh mode of the present invention, there is provided a method for producing a dielectric film of low dielectric constant, characterized in that the method comprises employing an etching method as recited in any of the first to eighth modes; and subjecting, to anisotropic etching, a dielectric film formed on the outermost surface of a substrate so that the etching does not penetrate through the film in a thickness direction, to thereby yield a dielectric film of low dielectric constant.

According to the eleventh mode, a dielectric film of low dielectric constant can be produced by subjecting a dielectric film to etching.

According to a twelfth mode of the present invention, there is provided a method for producing a porous member, characterized in that the method comprises employing an etching method as recited in any of the first to eighth modes; and subjecting a plate-like member to etching, to thereby yield a porous member having numerous through-holes which penetrate through the plate-like member in a thickness direction.

According to the twelfth mode, a porous member can be produced through formation of numerous through-holes in a plate-like member by subjecting the plate-like member to etching.

According to a thirteenth mode of the present invention, there is provided an etching apparatus characterized by comprising a chamber for accommodating an etching member; halogen radical supply means for supplying, into the chamber, halogen radicals generated from a halogen through formation of a plasma thereof; precursor supply means for supplying, into the chamber, a precursor formed from the halogen and a noble metal component generated through etching of a noble metal member by the halogen radicals; and etching control means for controlling the flux ratio of the precursor to the halogen radicals, as well as at least one of the temperature of the target and the temperature of the etching member, so as to perform an adsorption step of causing crystal nuclei of the precursor to be adsorbed on the etching member, and an etching step of anisotropically etching, in a thickness direction by the halogen radicals, a portion of the etching member on which the crystal nuclei have been adsorbed.

According to the thirteenth mode of the present invention, for example, micropores of high aspect ratio can be formed, since the flux ratio of the precursor to the halogen radicals, as well as at least one of the temperature of the target and the temperature of the etching member are controlled, so as to perform the adsorption step of causing crystal nuclei of the precursor to be adsorbed on the etching member, and the etching step of anisotropically etching, in a thickness direction by the halogen radicals, a portion of the etching member on which the crystal nuclei have been adsorbed.

A fourteenth mode of the present invention is drawn to a specific embodiment of the etching apparatus according to the thirteenth mode, wherein the system composed of the halogen radical supply means and the precursor supply means comprises a noble metal member located at a position facing the etching member in the interior of the chamber, working gas supply means for supplying a halogen-containing working gas into the chamber, and working gas plasma generation means for generating halogen radicals from the working gas through formation of a plasma thereof in the interior of the chamber, and for etching the noble metal member by the halogen radicals, thereby forming a precursor from the halogen and a noble metal component; the etching apparatus further comprises etching temperature control means for respectively controlling the temperature of the noble metal member and the temperature of the etching member; and the etching control means has a function of performing the adsorption step by controlling, through the etching temperature control means, the temperature of the etching member to a lower temperature so that crystal nuclei of the precursor are adsorbed on the etching member, as well as a function of performing the etching step by controlling, through the etching temperature control means, the temperature of the etching member to a higher temperature so that a portion of the etching member on which the crystal nuclei have been adsorbed is anisotropically etched in a thickness direction by the halogen radicals.

According to the fourteenth mode, since the temperature of the etching member is changed by the etching temperature control means, in the adsorption step, the crystal nuclei are efficiently adsorbed on the member, and in the etching step, etching is promoted without adsorption of the crystal nuclei.

A fifteenth mode of the present invention is drawn to a specific embodiment of the etching apparatus according to the fourteenth mode, wherein the etching control means has a function of changing, through the etching temperature control means, the temperature of the noble metal member to a higher temperature for increasing the size of the crystal nuclei or to a lower temperature for reducing the size of the crystal nuclei during etching of the noble metal member by the halogen radicals.

According to the fifteenth mode, during etching of the noble metal member by the halogen radicals, the temperature of the noble metal member can be controlled by the etching temperature control means; i.e., the temperature of the noble metal member can be changed to a higher temperature for increasing the size of the crystal nuclei, or the temperature of the noble metal member can be changed to a lower temperature for reducing the size of the crystal nuclei.

In a sixteenth mode of the present invention, there is provided a thin film formation apparatus having a chamber for accommodating a member which is to be etched and on which a film is formed (hereinafter may be referred to as an "etching and film formation member"); a metal member for forming a film of the metal (hereinafter may be referred to as a "film-forming metal member") provided in the chamber at a position facing the etching and film formation member; working gas supply means for supplying a halogen-containing working gas into the chamber; working gas plasma generation means for generating halogen radicals from the working gas through formation of a plasma thereof in the interior of the chamber, and for etching the film-forming metal member by the halogen radicals, thereby forming a precursor from the halogen and the metal component contained in the film-forming metal member; and film formation temperature control means for controlling the temperature of the substrate to be lower than that of the etching member so that a thin film formed of the metal component generated through reduction of the precursor by the halogen radicals is provided on the substrate, wherein the thin film formation apparatus further comprises halogen radical supply means for supplying halogen radicals into the chamber at a position above the etching and film formation member, the halogen radicals being generated from a halogen through formation of a plasma thereof, characterized in that the apparatus comprises precursor supply means for supplying a precursor into the chamber at a position above the etching and film formation member, the precursor being formed from the halogen and a noble metal component generated through etching of a noble metal member by the halogen radicals; etching temperature control means for respectively controlling the temperature of the noble metal member, and the temperature of the etching and film formation member; and etching control means for controlling the flux ratio of the precursor to the halogen radicals, as well as at least one of the temperature of the target and the temperature of the etching and film formation member, so as to perform an adsorption step of causing crystal nuclei of the precursor to be adsorbed on the etching and film formation member, and an etching step of anisotropically etching, in a thickness direction by the halogen radicals, a portion of the etching and film formation member on which the crystal nuclei have been adsorbed.

According to the sixteenth mode of the present invention, since the film-forming metal member is etched by the halogen radicals, to thereby form a precursor from the halogen and the metal component contained in the film-forming metal member, a thin film formed of the metal component generated through reduction of the precursor by the halogen radicals can be provided on the substrate. In addition, since there are performed the adsorption step of causing crystal nuclei of the precursor to be adsorbed on the etching member, as well as the etching step of anisotropically etching, in a thickness direction by the halogen radicals, a portion of the etching member on which the crystal nuclei have been adsorbed, for example, micropores of high aspect ratio can be formed.

A seventeenth mode of the present invention is drawn to a specific embodiment of the thin film formation apparatus according to the sixteenth mode, wherein the etching control means has a function of performing the adsorption step by controlling, through the etching temperature control means, the temperature of the etching and film formation member to a lower temperature so that crystal nuclei of the precursor are adsorbed on the etching and film formation member, as well as a function of performing the etching step by controlling, through the etching temperature control means, the temperature of the etching and film formation member to a higher temperature so that a portion of the etching and film formation member on which the crystal nuclei have been adsorbed is anisotropically etched in a thickness direction by the halogen radicals.

According to the seventeenth mode, since the temperature of the etching member is changed by the etching temperature control means, in the adsorption step, the crystal nuclei are efficiently adsorbed on the member, and in the etching step, etching is promoted without adsorption of the crystal nuclei.

An eighteenth mode of the present invention is drawn to a specific embodiment of the thin film formation apparatus according to the seventeenth mode, wherein the etching control means has a function of changing, through the etching temperature control means, the temperature of the noble metal member to a higher temperature for increasing the size of the crystal nuclei or to a lower temperature for reducing the size of the crystal nuclei during etching of the noble metal member by the halogen radicals.

According to the eighteenth mode, during etching of the noble metal member by the halogen radicals, the temperature of the noble metal member can be controlled by the etching temperature control means; i.e., the temperature of the noble metal member can be changed to a higher temperature for increasing the size of the crystal nuclei, or the temperature of the noble metal member can be changed to a lower temperature for reducing the size of the crystal nuclei.

### Effects of the Invention

The present invention, which is an application of the new-system CVD technique, employs a noble metal member as a target, and performs an adsorption step of causing crystal nuclei of a precursor to be adsorbed on an etching member, as well as an etching step of anisotropically etching, in a thickness direction by halogen radicals, a portion of the etching member on which the crystal nuclei have been adsorbed. Therefore, the present invention can form, for example, micropores of high aspect ratio.

Employment of this etching technique realizes formation of a low-dielectric-constant member having a predetermined dielectric constant, and production of a porous material having a predetermined porosity.

### Brief Description of the Drawings

[Fig. 1] Fig. 1 is a schematic representation of the configuration of an etching apparatus according to a first embodiment of the present invention.
[Fig. 2] Fig. 2 is a cross-sectional view of etching apparatus shown in the Fig. 1, as taken along line I-I.
[Fig. 3] Fig. 3 is a time-series chart showing a mode of an etching method employing the apparatus shown in Fig. 1.
[Fig. 4] Fig. 4 schematically shows the state of etching through the adsorption step and the etching step of the etching method of the present invention.
[Fig. 5] Fig. 5 schematically shows a process for selective adsorption of crystal nuclei in the etching method of the present invention.
[Fig. 6] Fig. 6 is a schematic representation of the configuration of an etching apparatus according to a second embodiment of the present invention.
[Fig. 7] Fig. 7 is a schematic representation of the configuration of an etching apparatus according to a third embodiment of the present invention.
[Fig. 8] Fig. 8 is a schematic representation of the configuration of a thin film formation apparatus according to a fourth embodiment of the present invention.
[Fig. 9] Fig. 9 is a schematic representation of the configuration of a ULSI to which the etching method of the present invention can be applied.

### Description of Reference Numerals

1: Chamber
3: Substrate
6, 106: Etching temperature control means
7: Ceiling board
8: Plasma antenna
9: Matching box
10: High-frequency power supply
11: Noble metal member
14: Nozzle
15: Flow rate controller
16: Nozzle
21: Working gas
110: Etching control means
219: Copper thin film

### Best Modes for Carrying Out the Invention

Embodiments of the present invention will next be described in detail with reference to the drawings. Components common to these embodiments are denoted by the same reference numerals, and repeated description thereof is omitted.

### <First embodiment>

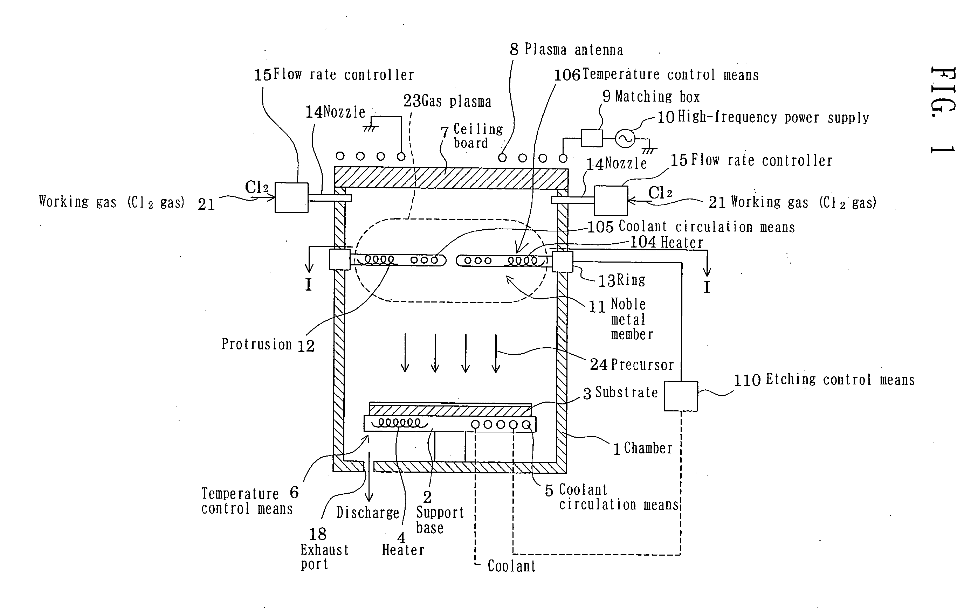

Fig. 1 is a schematic representation of the configuration of an etching apparatus according to the first embodiment of the present invention. As shown in Fig. 1, a support base 2 is provided in the vicinity of the bottom of a cylindrical chamber 1 made of, for example, ceramic material, and a substrate 3, serving as an etching member, is placed on the support base 2. The support base 2 is provided with etching temperature control means 6 including a heater 4 and coolant circulation means 5, and the temperature of the support base 2 is controlled by the etching temperature control means 6 to a predetermined temperature (e.g., a temperature required for maintaining the substrate 3 at 100°C to 300°C). The shape of the chamber is not limited to a cylindrical shape, and, for example, a rectangular chamber may be employed.

The top of the chamber 1 is opened, and the opening is covered with a flat-plate-like ceiling board 7 made of ceramic material (i.e., insulating material): The chamber 1 does not necessarily have the ceiling board 7 as a separate member, and may be a chamber integrally including a ceiling board. Above the ceiling board 7 is provided a plasma antenna 8 for forming a plasma of a gas supplied into the chamber 1. The plasma antenna 8 is provided in the form of flat ring so as to be parallel to the surface of the ceiling board 7. The plasma antenna 8 is connected to a matching box 9 and a high-frequency power supply 10 so that a high-frequency electromagnetic wave is introduced into the chamber 1 via the plasma antenna 8. The plasma antenna 8, the matching box 9, and the high-frequency power supply 10 constitute plasma generation means.

A noble metal member 11 is made of a noble metal capable of forming a halide (iridium (Ir) in the present embodiment), and is provided in the interior of the chamber 1 at a position below the plasma antenna 8. The noble metal member 11 is provided for forming a precursor from a halogen and a noble metal component generated through etching of the member by a halogen plasma. The halogen plasma is formed from a halogen (chlorine in the present embodiment)-containing working gas supplied into the chamber 1 through formation of a plasma thereof by means of a high-frequency electromagnetic energy supplied through the plasma antenna 8.

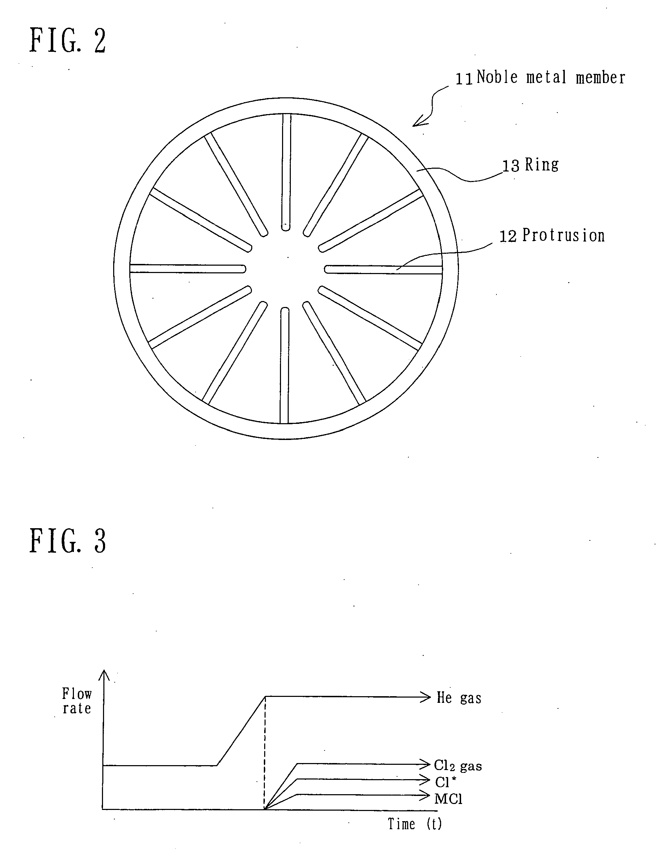

As shown in Fig. 2, which is a cross-sectional view of the noble metal member 11 shown in Fig. 1, as taken along line I-I, the noble metal member 11 includes rod-like protrusions 12 and a ring 13. Base ends of the protrusions 12 are fixed to the ring 13 so that the protrusions 12 extend toward the center of the chamber 1, and that the tip end of each of the protrusions 12 does not come into contact with the tip end of an adjacent protrusion 12. With this configuration, the protrusions 12 are electrically independent of one another, and do not shield an electromagnetic field which is generated by the plasma antenna 8 and is introduced into the chamber 1. The noble metal member 11 is configured so as to be discontinuous in a circumferential direction; i.e., the direction in which electricity flows through the plasma antenna 8. The noble metal member may be configured to have, for example, a gridlike structure or a net-like structure so that the configuration of the noble metal member is discontinuous in a direction in which electricity flows through the plasma antenna 8.

The noble metal member 11 is further provided with etching temperature control means 106 including a heater 104 and coolant circulation means 105, so that the temperature of the noble metal member 11 can be controlled to a predetermined temperature. The noble metal member 11, which is heated by the below-described gas plasma 23, may be maintained at a predetermined temperature through control of the gas plasma 23. In this case, the aforementioned plasma generation means serves as etching temperature control means.

The etching temperature control means 6 and 106 are controlled by etching control means 110.

On the periphery of the cylindrical chamber 1 are provided, at regular intervals in a circumferential direction, a plurality of nozzles 14 (e.g., eight nozzles (two nozzles are shown in Fig. 1)) serving as working gas supply means for supplying, into the chamber 1, a working gas 21 containing chlorine (i.e., a halogen); specifically, a working gas prepared through dilution with He so that the chlorine concentration is 50% or less (preferably, about 10%). The working gas 21 is fed to each of the nozzles 14 via a flow rate controller 15 for controlling the flow rate and pressure of the working gas 21. As shown in Fig. 1, each of the nozzles 14 is provided with a single flow rate controller 15. However, a single flow rate controller 15 is enough for all the nozzles 14. Alternatively, each set of a plurality of nozzles 14 may have a single flow rate controller 15.

Gas and other material which do not participate in film formation are discharged through an exhaust port 18, and the interior of the chamber 1, which is covered with the ceiling board 7, is maintained at a predetermined vacuum by means of a vacuum pump (not illustrated).

An etching mode of the etching method employing the etching apparatus will now be described with reference also to Fig. 3, which shows the time-series state of the interior of the chamber 1 of the etching apparatus.

As shown in Fig. 3, firstly, He gas is supplied into the chamber 1, followed by preliminary heating, while an electromagnetic field generated by high-frequency electric power is introduced into the chamber 1 via the plasma antenna 8. At the time when the temperature of the noble metal member 11 reaches a predetermined temperature through preliminary heating, the Cl₂-gas-containing working gas 21 is supplied into the chamber 1 via the flow rate controllers 15 and the nozzles 14, whereby chlorine radicals (Cl*) are generated through formation of a plasma of chlorine contained in the working gas 21. The gas plasma 23 shown in Fig. 1 is a chlorine plasma.

While the noble metal member 11 is etched by chlorine radicals (Cl*), to thereby form a precursor 24 from the noble metal (i.e., iridium (Ir)) and the halogen, the temperature of the substrate 3 is controlled so as to be lower than that of the noble metal member 11 by at least one of the etching temperature control means 6 and 106, to thereby cause crystal nuclei of the precursor 24 (MCl) to be adsorbed on the surface of the substrate 3. Thus, a predetermined amount of the crystal nuclei is adsorbed on the substrate 3. The aforementioned procedure corresponds to an adsorption step.

Subsequently, the temperature of the substrate 3 is controlled to a higher temperature by the etching temperature control means 6 and 106 so that the precursor 24 is not adsorbed on the substrate 3. In this state, chlorine radicals (Cl*) act selectively on the crystal nuclei adsorbed on the substrate 3, and only the crystal nuclei and a region on which the crystal nuclei have been adsorbed are anisotropically etched in a thickness direction of the substrate 3. As used herein, the term "anisotropic etching" refers to the case where the etching rate in a thickness direction is considerably higher than that in a direction crossing therewith, and etching proceeds only in a thickness direction in a manner generally dependent on the size of adsorbed crystal nuclei. Therefore, pores having a size corresponding to that of the adsorbed crystal nuclei are formed in the same number as the crystal nuclei.

The aforementioned procedure corresponds to an etching step. The adsorption step and the etching step are not clearly discriminated from each other. Under some conditions, anisotropic etching may proceed in parallel with adsorption in the adsorption step. The amount of crystal nuclei is controlled by the timing of transition from the adsorption step to the etching step, and the degree of etching (i.e., pore depth) is controlled by, for example, the time of the etching step, the amount of chlorine radicals (Cl*), or the temperature of the substrate 3. Specifically, the longer the time of the etching step (or the greater the amount of chlorine radicals (Cl*), or the higher the temperature of the substrate 3), the greater the depth of pores formed. The anisotropic etching rate-which varies depending on, for example, the temperature of the substrate 3 or the material of an etching target firm-is, for example, about 1 µm/min.

In the above-described adsorption step and etching step, the etching temperature control means 6 and 106 are controlled by the etching control means 110. Specifically, in the present embodiment, the etching control means 110 has a function of controlling the etching temperature control means 6 and 106, to thereby perform the adsorption step through, for example, control of the temperature of the substrate 3 to a lower temperature so that crystal nuclei of the precursor 24 are adsorbed on the substrate 3, as well as a function of controlling the etching temperature control means 6 and 106, to thereby perform the etching step through, for example, control of the temperature of the substrate 3 to a higher temperature so that a portion of the substrate 3 on which the crystal nuclei have been adsorbed is anisotropically etched in a thickness direction by chlorine radicals (C1*). Thus, when the temperature of the substrate 3 is controlled to a lower temperature, the precursor 4 is more readily adsorbed on the substrate 3, whereas when the temperature of the substrate 3 is controlled to a higher temperature, the precursor 24 is more difficult to adsorb on the substrate 3.

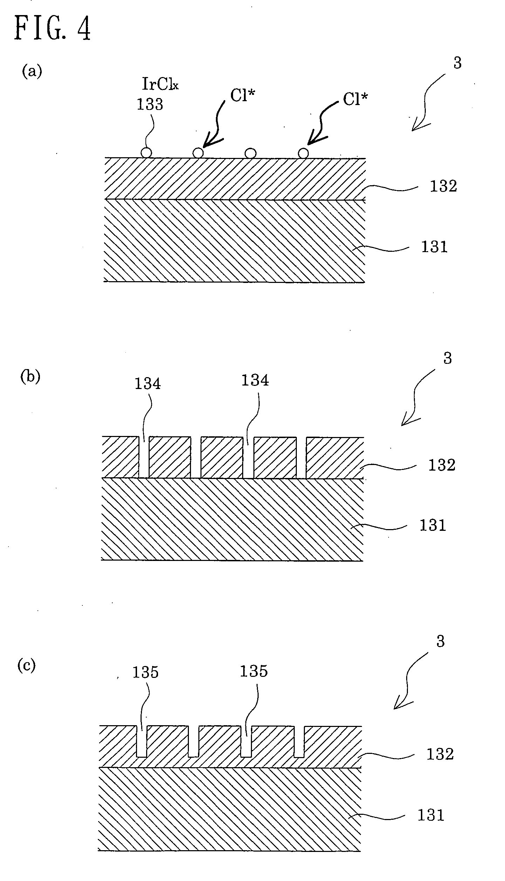

Fig. 4 schematically shows the state of etching through the aforementioned adsorption step and etching step. Fig. 4(a) shows the adsorption step employing, as the substrate 3, a silicon substrate 131 on which a silicon oxide film 132 is formed, and shows the state where a plurality of crystal nuclei 133 of iridium chloride (IrClₓ) are adsorbed on the silicon oxide film 132. Fig. 4(a) also shows the state where, in the etching step following the adsorption step, chlorine radicals (Cl*) act on the crystal nuclei 133 adsorbed on the silicon oxide film 132. When anisotropic etching proceeds through action of chlorine radicals (Cl*), as shown in Fig. 4(b), pores 134 having a diameter corresponding to the size of the crystal nuclei 133 are formed. Fig. 4(b) shows the case where anisotropic etching is performed until the pores penetrate through the silicon oxide film 132. However, as shown in Fig. 4(c), pores 135 which do not penetrate through the silicon oxide film 132 in a thickness direction can be formed through regulation of the time of the etching step.

As described above, the etching control means 110 controls transition from the adsorption step to the etching step by controlling the etching temperature control means 6 and 106. However, transition from the adsorption step to the etching step may be controlled by changing the flux ratio of chlorine radicals (Cl*) to the precursor 24 formed from iridium (Ir) and the halogen. Specifically, in the adsorption step, the flux of the precursor 24 may be controlled to be greater than that of chlorine radicals (Cl*), whereas in the etching step, the flux of chlorine radicals (Cl*) may be controlled to be greater than that of the precursor 24. For example, in the adsorption step, the flow rate of the working gas 21 is controlled by means of the flow rate controller 15 so that the amount of chlorine radicals (Cl*) is regulated to such a level that is required only for etching of the noble metal member 11; i.e., the amount of free chlorine radicals (Cl*) is reduced to a minimum level possible. Meanwhile, in the etching step, the flow rate of the working gas 21 is controlled by means of the flow rate controller 15 so as to exceed an appropriate flow rate as determined in the adsorption step, so that the amount of chlorine radicals (Cl*) is greater than that of the precursor 24. The flow rate controller 15 is controlled by the etching control means 110. In this case, the temperature of the noble metal member 11 may be controlled in parallel with the temperature of the substrate 3. For example, the temperature of the noble metal member 11 may be reduced by the etching temperature control means 106 so that the noble metal member 11 is less likely to be etched, or the temperature of the substrate 3 may be controlled to a higher temperature by the etching temperature control means 6 so that the precursor 24 is less likely to be adsorbed on the substrate 3.

During etching of the noble metal member 11 by halogen radicals, the size of crystal nuclei which are adsorbed on the substrate 3 can be regulated. Specifically, in order to increase the size of crystal nuclei which are adsorbed on the substrate 3, the temperature of the noble metal member 11 is changed to a higher temperature, whereas in order to reduce the size of crystal nuclei which are adsorbed on the substrate 3, the temperature of the noble metal member 11 is changed to a lower temperature. That is, the higher the temperature of the noble metal member 11, the greater the size of clusters of the precursor 24 formed through etching by chlorine radicals (Cl*). As a result, large crystal nuclei are adsorbed on the substrate 3. Such control of the temperature of the noble metal member 11 is performed by the etching temperature control means 6.

Thus, when the size of crystal nuclei which are adsorbed on the substrate 3 is controlled, and, as described above, the depth of pores formed through anisotropic etching is controlled through regulation of the time of etching, the aspect ratio of the thus-formed pores can be varied.

According to the etching method of the present invention, micropores having a diameter of about 10 nm can be formed. In the case where micropores having a diameter of about 10 nm are formed, anisotropic etching can be performed until the pores have a depth of about 100 nm, and thus the aspect ratio (i.e., depth/diameter) of the pores is about 10.

In the etching method of the present invention, crystal nuclei are discretely adsorbed on the substrate 3, and therefore a plurality of pores are formed so as to be arranged discretely from one another. The number of such pores can be controlled by the time of adsorption or the amount of the precursor 24. A region of the substrate 3 on which crystal nuclei have been adsorbed (i.e., an etching region) can be appropriately determined by, for example, forming a mask on the substrate 3 from a resist or a similar material so that only an etching region is opened. Thus, crystal nuclei can be discretely adsorbed only on the thus-determined etching region. Subsequently, when the etching step is performed, a plurality of pores are discretely formed only within the etching region. Such an etching region may be determined by, in place of the aforementioned masking method employing a resist or a similar material, changing the material of a film on the surface of the substrate 3. For example, such an etching region can be determined by providing a metal film only on the etching region and providing an oxide film on a region other than the etching region, since crystal nuclei are adsorbed more easily on a metal film than on an oxide film. Alternatively, a region other than an etching region may be subjected to a processing so that crystal nuclei are less likely to adsorb thereon, or only the etching region may be subjected to a processing so that crystal nuclei are selectively adsorbed thereon.

In addition to such an etching region, pores formed through the etching method of the present invention can be spotted, whereby through-holes (e.g., pores for via holes) can be formed at a predetermined position. An example of such a pore formation method will now be described.

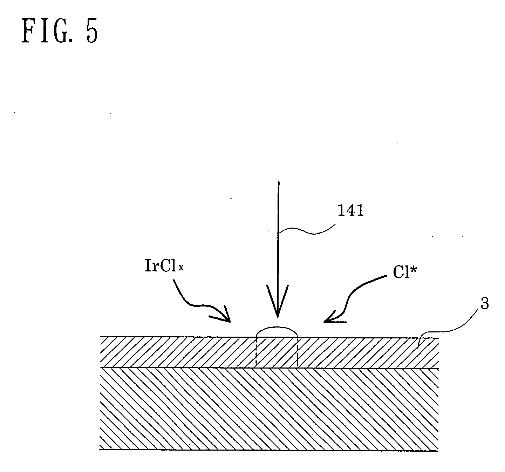

As shown in Fig. 5, a predetermined region of the substrate 3 in which pores are to be formed through anisotropic etching is irradiated with an excitation beam 141, which is a secondary electron beam. The excitation beam 141 is preferably an electron beam, but may be, for example, an X-ray or a UV ray. When the excitation beam 141 is an electron beam, the electron beam may have, for example, an acceleration voltage of 200 to 500 eV. Thus, in the case where a predetermined region is irradiated with the excitation beam 141, when, for example, the temperature of the substrate 3 is regulated to such a high temperature that crystal nuclei are not adsorbed thereon, iridium chloride (i.e., a precursor 24) acts selectively on a point irradiated with the excitation beam 141, and iridium is adsorbed on the irradiated point. Chlorine radicals (Cl*) act on the thus-adsorbed iridium, to thereby form crystal nuclei of iridium chloride. After adsorption of the crystal nuclei only on such a predetermined point, the aforementioned etching step is performed, whereby, for example, through-holes of high aspect ratio can be formed at the predetermined point.

The aforementioned etching method of the present invention can be applied to a semiconductor process for forming via holes which penetrate through a thin film. In addition, when, for example, the time of the etching step is extremely shortened, the etching method can be employed for roughening the surface of a thin film. Specifically, the amount of crystal nuclei which are adsorbed on the thin film surface is relatively increased so that the crystal nuclei are adsorbed on virtually the entire surface, and then the etching step is performed to such an extent that no pores are formed. Thus, the thin film surface can be roughened, and adhesion between the thin film and a film formed thereon can be enhanced.

### <Second embodiment>

In the aforementioned first embodiment, a chlorine plasma employed in the adsorption step and the etching step is formed by one plasma generation means. However, a chlorine plasma employed in the adsorption step and a chlorine plasma employed in the etching step may be independently formed by different plasma generation means.

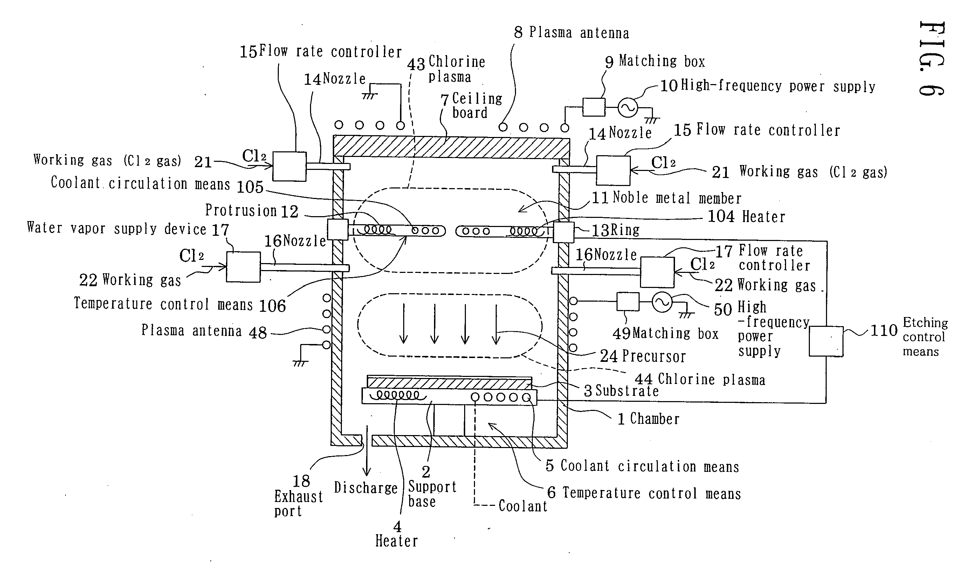

Fig. 6 is a schematic representation of the configuration of an etching apparatus according to the second embodiment of the present invention, in which a chlorine plasma employed in the adsorption step and a chlorine plasma employed in the etching step are independently formed by different plasma generation means.

As shown in Fig. 6, in the etching apparatus according to the present embodiment, a plasma antenna 48 having a coil-like form is provided on the periphery of a lower portion of a chamber 1. The plasma antenna 48 is connected to a high-frequency power supply 50 via a matching box 49, and the plasma antenna 48, the matching box 49, and the high-frequency power supply 50 constitute another plasma generation means.

Similar to the case of nozzles 14, on the periphery of a lower portion of the chamber 1 are provided, at regular intervals in a circumferential direction, a plurality of nozzles 16 (e.g., eight nozzles (two nozzles are shown in Fig. 6)) serving as working gas supply means for supplying a working gas 22 containing chlorine (i.e., a halogen); specifically, a working gas prepared through dilution with He so that the chlorine concentration is 50% or less (preferably, about 10%). The working gas 22 is fed to each of the nozzles 16 via a flow rate controller 17 for controlling the flow rate and pressure of the working gas 22 so that the working gas 22 is supplied to the lower portion of the chamber 1. As shown in Fig. 6, each of the nozzles 16 is provided with a single flow rate controller 17. However, a single flow rate controller 17 is enough for all the nozzles 16. Alternatively, each set of a plurality of nozzles 16 may have a single flow rate controller 17.

According to the present embodiment, in the adsorption step, firstly, He gas is supplied into the chamber 1, followed by preliminary heating. At the time when the temperature of a noble metal member 11 reaches a predetermined temperature through preliminary heating, a Cl₂-gas-containing working gas 21 is supplied into the chamber 1 via flow rate controllers 15 and the nozzles 14, whereby chlorine radicals (Cl*) are generated through formation of a plasma of chlorine contained in the working gas 21 (i.e., formation of a chlorine plasma 43). The noble metal member 11 is etched by chlorine radicals (Cl*), to thereby form a precursor 24 from the noble metal (i.e., iridium (Ir)) and the halogen. In parallel with this, the temperature of a substrate 3 is controlled so as to be lower than that of the noble metal member 11 by at least one of etching temperature control means 6 and 106, to thereby cause crystal nuclei of the precursor 24 to be adsorbed on the surface of the substrate 3. Through the aforementioned procedure (i.e., the adsorption step), a predetermined amount of the crystal nuclei is adsorbed on the substrate 3.

Subsequently, supply of the working gas 21 (i.e., Cl₂ gas) into the chamber 1 via the flow rate controllers 15 and the nozzles 14 is stopped, and the Cl₂-gas-containing working gas 22 is supplied, via the flow rate controllers 17 and the nozzles 16, into the chamber 1 below the noble metal member 11. Thus, a plasma of Cl₂ gas (i.e., a chlorine plasma 44) is formed by the plasma generation means consisting of the plasma antenna 48, the matching box 49, and the high-frequency power supply 50. In this case, the noble metal member 11 is not etched by chlorine radicals (Cl*), and formation of the precursor 24 is stopped. Chlorine radicals (Cl*) act selectively on the crystal nuclei adsorbed on the surface of the substrate 3, and the crystal nuclei and a region on which the crystal nuclei have been adsorbed are anisotropically etched, whereby, similar to the case of the first embodiment, pores having a size corresponding to that of the adsorbed crystal nuclei are formed in the same number as the crystal nuclei. In the case of the present embodiment, in the etching step, the temperature of the substrate 3 is not necessarily controlled to a higher temperature by the etching temperature control means 6 and 106 so that the precursor 24 is not adsorbed on the substrate 3. However, such temperature control may be performed.

### <Third embodiment>

In the aforementioned embodiments, chlorine radicals are generated in the interior of the chamber 1 in each of the adsorption step and the etching step. However, chlorine radicals generated outside the chamber 1 may be introduced into the chamber 1 in any or both of these steps. An etching apparatus according to the third embodiment is of a so-called remote plasma type, in which chlorine radicals employed in the etching step are generated outside a chamber 1.

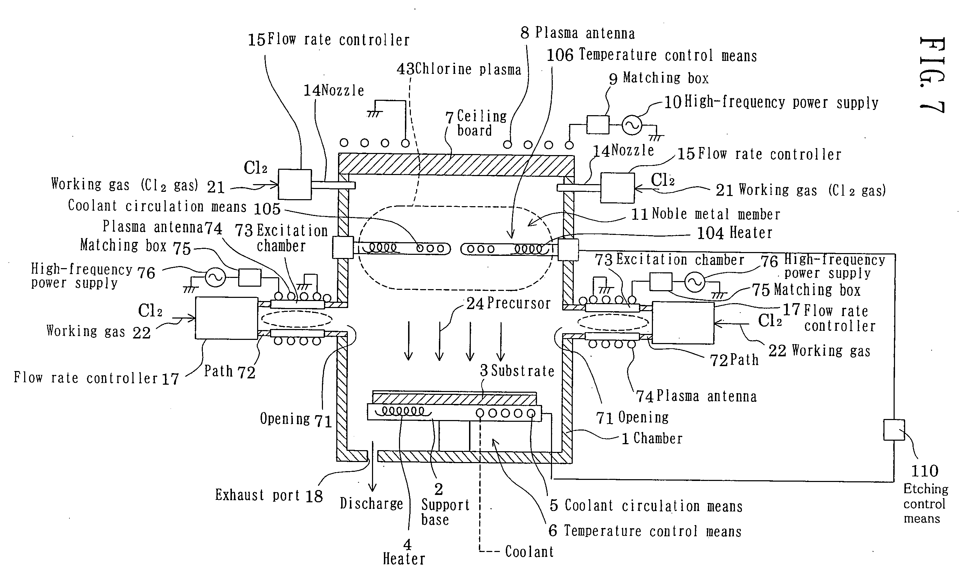

Fig. 7 is a schematic representation of the configuration of an etching apparatus according to the third embodiment of the present invention. As shown in Fig. 7, a plurality of openings 71 (e.g., four openings) are provided on the periphery of a lower portion of the chamber 1, and one end of a tubular path 72 is fixed to each of the openings 71. An excitation chamber 73 made of insulating material is provided on the course of path 72, and a coil-form plasma antenna 74 is provided on the periphery of the excitation chamber 73. The plasma antenna 74 is connected to a high-frequency power supply 76 via a matching box 75. The other end of the path 72 is connected to a flow rate controller 17 for controlling the flow rate and pressure of a working gas 22, and the working gas 22 is supplied into the path 72 via the flow rate controller 17.

In the case of this etching apparatus, in the adsorption step, firstly, He gas is supplied into the chamber 1, followed by preliminary heating. At the time when the temperature of a noble metal member 11 reaches a predetermined temperature through preliminary heating, a Cl₂-gas-containing working gas 21 is supplied into the chamber 1 via flow rate controllers 15 and nozzles 14, whereby chlorine radicals (Cl*) are generated through formation of a plasma of chlorine contained in the working gas 21 (i.e., formation of a chlorine plasma 43). The noble metal member 11 is etched by chlorine radicals (Cl*), to thereby form a precursor 24 from the noble metal (i.e., iridium (Ir)) and the halogen. In parallel with this, the temperature of a substrate 3 is controlled so as to be lower than that of the noble metal member 11 by at least one of etching temperature control means 6 and 106, to thereby cause crystal nuclei of the precursor 24 to be adsorbed on the surface of the substrate 3. Through the aforementioned procedure (i.e., the adsorption step), a predetermined amount of the crystal nuclei is adsorbed on the substrate 3.

Subsequently, supply of the Cl₂-gas-containing working gas 21 into the chamber 1 via the flow rate controllers 15 and the nozzles 14 is stopped; a chlorine gas 22 is supplied into the flow rate controllers 17 and the paths 72; and an electromagnetic wave is introduced through the plasma antennas 74 into the excitation chambers 73, whereby chlorine radicals (Cl*) generated through formation of a plasma of the chlorine gas are introduced into the chamber 1 through the openings 71. In this case, the noble metal member 11 is not etched by chlorine radicals (Cl*), and the precursor 24 is not formed. Chlorine radicals (Cl*) act selectively on the crystal nuclei adsorbed on the surface of the substrate 3, and the crystal nuclei and a region on which the crystal nuclei have been adsorbed are anisotropically etched, whereby, similar to the case of the first embodiment, pores having a size corresponding to that of the adsorbed crystal nuclei are formed in the same number as the crystal nuclei. In the case of the present embodiment, in the etching step, the temperature of the substrate 3 is not necessarily controlled to a higher temperature by the etching temperature control means 6 and 106 so that the precursor 24 is not adsorbed on the substrate 3. However, such temperature control may be performed.

### <Fourth embodiment>

The above-described embodiments correspond to the etching apparatus of the present invention. The present embodiment, which will now be described, corresponds to a thin film formation apparatus including the etching apparatus of the present invention.

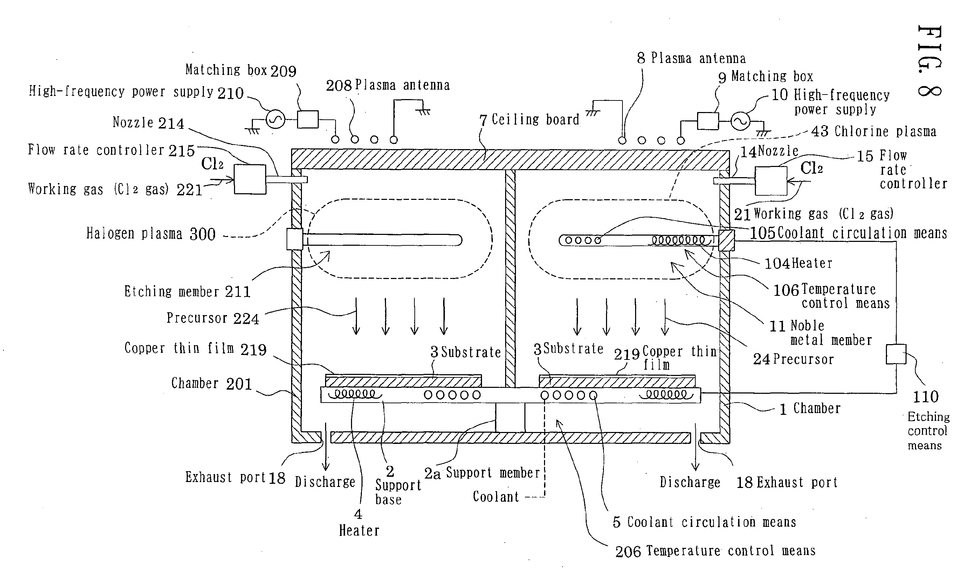

Fig. 8 is a schematic representation of the configuration of a thin film formation apparatus according to the fourth embodiment of the present invention. As shown in Fig. 8, the thin film formation apparatus includes a chamber 1 for etching which is made of, for example, ceramic material; and a chamber 201 for thin film formation which is made of, for example, ceramic material. A support base 2 is provided in the vicinity of the bottom of the chamber 1, and the support base 2 is rotatably provided via a support member 2a. The support base 2 is rotated by means of a non-illustrated rotary apparatus so that a substrate 3 (i.e., an etching and film formation member) placed on the support base 2 can be transferred within the chambers 1 and 201. The support base 2 is provided with etching temperature control means 206 including a heater 4 and coolant circulation means 5, and the temperature of the support base 2 is controlled by the etching temperature control means 206 to a predetermined temperature (e.g., a temperature required for maintaining the substrate 3 at 100°C to 300°C) .

The top of each of the chambers 1 and 201 is open, and the opening is covered with a flat-plate-like ceiling board 7 made of ceramic material (i.e., insulating material). The chamber 1 does not necessarily have the ceiling board 7 as a separate member, and may be a chamber having a ceiling board united therewith. Above the ceiling board 7 of the chambers 1 and 201 are respectively provided plasma antennas 8 and 208 for forming a plasma of a gas supplied into the chamber 1. The plasma antennas 8 and 208 are provided in the form of flat ring so as to be parallel to the surface of the ceiling board 7. The plasma antennas 8 and 208 are respectively connected to matching boxes 9 and 209, and high-frequency power supplies 10 and 210 so that a high-frequency electromagnetic wave is introduced into the chambers 1 and 201 via the plasma antennas 8 and 208, respectively. The plasma antenna 8, the matching box 9, and the high-frequency power supply 10 constitute plasma generation means for the chamber 1; and the plasma antenna 208, the matching box 209, and the high-frequency power supply 210 constitute plasma generation means for the chamber 201.

A noble metal member 11 is provided in the chamber 1 in a manner similar to that of the aforementioned embodiments. Meanwhile, an etching member 211 having a structure similar to that of the noble metal member 11 is provided in the chamber 201. The etching member 211 is made of, for example, a metal capable of forming a halide (e.g., copper (Cu)), and is provided in the interior of the chamber 201 at a position below the plasma antenna 208. The etching member 211 is provided for forming a precursor from a halogen and a metal component (e.g., copper) generated through etching of the member by a halogen plasma. A halogen plasma 300 is formed from a halogen (chlorine in the present embodiment)-containing working gas 221 supplied into the chamber 201 by means of a high-frequency electromagnetic energy supplied through the plasma antenna 208.

Similar to the case of the chamber 1, on the periphery of the chamber 201 are provided, at regular intervals in a circumferential direction, a plurality of nozzles 214 serving as working gas supply means for supplying, into the chamber 201, a working gas 221 containing chlorine (i.e., a halogen); specifically, a working gas prepared through dilution with He so that the chlorine concentration is 50% or less (preferably, about 10%). The working gas 221 is fed to each of the nozzles 214 via a flow rate controller 215 for controlling the flow rate and pressure of the working gas 221.

In a film formation step employing the chamber 201, film formation is performed in a manner similar to that in the case of a conventional technique. Specifically, while the etching member 211 is etched by chlorine radicals (Cl*) generated through formation of a plasma of the working gas 221 (C1₂ gas), to thereby form a precursor 224 from the metal (i.e., copper) and the halogen, the temperature of the substrate 3 is controlled so as to be lower than that of the etching member 211 by the temperature control means 206. When the flux ratio of the precursor 224 (MCl) to chlorine radicals (Cl*) falls within a predetermined range, formation of a copper thin film 219 from copper generated through reduction of the precursor 224 by chlorine radicals (Cl*) is initiated. Specifically, film formation is considered to proceed through, for example, the following process: the precursor 224 (MCl) is adsorbed on the surface of the substrate 3, and then the precursor 224 (MC1) is reduced by chlorine radicals (Cl*), to thereby precipitate copper and to form a copper thin film 219.

In this film formation step, when the material of the etching member 211 is changed to, for example, A1, Ta, Ti, W, Zn, In, or Cd, a variety of metal films can be formed. The film formed through this step is not limited to such a metal film, and a silicon film or a silicon oxide film may be formed through this step.

In this thin film formation apparatus, when the support base 2 is rotated, the film formation step and the etching step can be performed alternately and continuously without discharging of the substrate 3 to the outside of the chamber. Specifically, the copper thin film 219 can be formed in the chamber 201; and, when the support base 2 is rotated so that the copper thin film 219 is located in the chamber 1, the thin film 219 can be subjected to a predetermined etching treatment (e.g., formation of via holes) through adsorption of a precursor 24 and selective etching by chlorine radicals, which realizes production of semiconductor devices. For example, a thin film can be formed in the chamber 201; via holes can be formed in the thin film in the chamber 1; and a material can be buried in the via holes in the chamber 201. Meanwhile, the surface of the copper thin film 219 formed in the chamber 201 can be roughened in the chamber 1 so that adhesion between the copper thin film 219 and a film which is formed thereon is enhanced, and subsequently additional thin film can be formed on the thin film 219 in the chamber 201.

### <Other embodiments>

As described above, micropores (e.g., through-holes) can be formed or the surface of a thin film can be roughened by means of the aforementioned etching apparatus or thin film formation apparatus. In addition, a porous member can be produced by means of the apparatus by, for example, forming numerous fine through-holes in a substrate 3 formed of a metallic plate-like member. The thus-produced porous member can be employed for a filter (e.g., a gas filter or a catalyst filter). Conventionally, a thin-film filter made of porous ceramic material has been employed as the aforementioned filter, but such a ceramic filter poses a problem in that it is difficult to recycle due to adsorption of the ceramic per se. However, the porous member produced through the etching method of the present invention solves such a problem.

When a thin film or a plate-like member is subjected to etching, to thereby form through-holes which penetrate therethrough in a thickness direction or micropores which do not penetrate therethrough in a thickness direction, the density of the thin film or plate-like member can be reduced. When such a technique is applied to a dielectric material, a dielectric film of low dielectric constant can be readily formed.

Conventionally, such a dielectric film of low dielectric constant has been formed through, for example, a method in which bubbles are caused to be contained in the film. However, such a method poses a problem in that the method encounters difficulty in controlling the amount of bubbles and in attaining a predetermined dielectric constant. In contrast, through application of the aforementioned etching technique of the present invention, the diameter, depth, and number of micropores can be controlled in a highly effective manner, and a dielectric film having a predetermined dielectric constant can be produced.

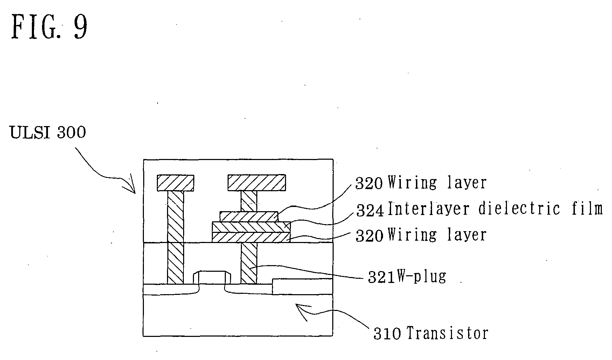

Such a dielectric film of low dielectric constant can be applied to, for example, an interlayer dielectric film of an ultra large scale integrated circuit (ULSI). Fig. 9 shows such a ULSI. As shown in Fig. 9, a ULSI 300 includes a transistor 310, wiring layers 320, and an interlayer dielectric film 324 provided therebetween. The interlayer dielectric film 324 is formed of, for example, a silicon oxide film. When, for example, a predetermined number of micropores are formed in a silicon oxide film so as not to penetrate therethrough in a thickness direction as shown in Fig. 4(c), the density of the film can be reduced, to thereby form a dielectric layer having a predetermined low dielectric constant.

For formation of such a dielectric layer of low dielectric constant, only micropores may be formed by means of the aforementioned etching apparatus, or steps (including formation of the transistor) may be performed by means of the aforementioned thin film formation apparatus. In this case, through-holes for forming a W-plug 321, or a dielectric film of low dielectric constant can be formed through the etching method of the present invention.

Thus, the apparatuses according to the aforementioned first to fourth embodiments, which can carry out the etching method of the present invention, are applicable to a variety of uses.

In the aforementioned first to fourth embodiments, the noble metal member 11 is made of Ir. However, the material of the member 11 is not limited thereto, and the member 11 may be made of a noble metal such as platinum (Pt). The raw material gas is not limited to Cl₂ gas, and may generally be a halogen gas.

### Industrial Applicability

The etching method, low-dielectric-constant dielectric film production method, porous member production method, etching apparatus, and thin film formation apparatus of the present invention are useful in a wide range of applications, including an industrial process for forming a thin film on the surface of a substrate (in particular, a process for producing a memory, a transistor, or an optical film), and production of a filter (e.g., a gas filter or a catalyst filter).

## Claims

1. An etching method **characterized by** comprising an adsorption step of employing halogen radicals generated from a halogen through formation of a plasma thereof, and a precursor formed from the halogen and a noble metal component generated through etching of a noble metal member by the halogen radicals, wherein crystal nuclei of the precursor are caused to be adsorbed on an etching member; and an etching step of anisotropically etching, in a thickness direction by the halogen radicals, a portion of the etching member on which the crystal nuclei have been adsorbed.

2. An etching method as described in claim 1, wherein the flux ratio of the precursor to the halogen radicals is changed in the adsorption step and the etching step so that, in the adsorption step, the flux of the precursor is controlled to be greater than that of the halogen radicals, whereas in the etching step, the flux of the halogen radicals is controlled to be greater than that of the precursor.

3. An etching method as described in claim 1 or 2, wherein the temperature of the etching member is changed in the adsorption step and the etching step so that, in the adsorption step, the temperature of the etching member is controlled to such a temperature that the crystal nuclei are adsorbed on the etching member, whereas in the etching step, the temperature of the etching member is controlled to be higher than that in the adsorption step so that etching by the halogen radicals is promoted without adsorption of the crystal nuclei.

4. An etching method as described in any of claims 1 to 3, wherein, when the noble metal member is etched by the halogen radicals, the temperature of the noble metal member is changed to a higher temperature for increasing the size of the crystal nuclei, or the temperature of the noble metal member is changed to a lower temperature for reducing the size of the crystal nuclei.

5. An etching method as described in any of claims 1 to 4, wherein the noble metal is iridium (Ir) or platinum (Pt).

6. An etching method as described in any of claims 1 to 5, wherein the crystal nuclei are caused to be discretely adsorbed on a predetermined etching region of the etching member.

7. An etching method as described in claim 6, wherein the outermost surface of the etching region of the etching member readily adsorbs the crystal nuclei, as compared with the outermost surface of a region other than the etching region.

8. An etching method as described in any of claims 1 to 7, wherein the crystal nuclei are caused to be adsorbed selectively on a portion which has been irradiated with an excitation beam.

9. An etching method as described in any of claims 1 to 8, wherein a surface of the etching member is roughened through anisotropic etching.

10. An etching method as described in any of claims 1 to 8, wherein the etching member is a thin film formed on the outermost surface of a substrate, and at least one through-hole which penetrates through the thin film is formed through anisotropic etching.

11. A method for producing a dielectric film of low dielectric constant, **characterized in that** the method comprises employing an etching method as recited in any of claims 1 to 8, and subjecting, to anisotropic etching, a dielectric film formed on the outermost surface of a substrate so that the etching does not penetrate through the film in a thickness direction, to thereby yield a dielectric film of low dielectric constant.

12. A method for producing a porous member, **characterized in that** the method comprises employing an etching method as recited in any of claims 1 to 8, and subjecting a plate-like member to etching, to thereby yield a porous member having numerous through-holes which penetrate through the plate-like member in a thickness direction.

13. An etching apparatus **characterized by** comprising
a chamber for accommodating an etching member;
halogen radical supply means for supplying, into the chamber, halogen radicals generated from a halogen through formation of a plasma thereof;
precursor supply means for supplying, into the chamber, a precursor formed from the halogen and a noble metal component generated through etching of a noble metal member by the halogen radicals; and
etching control means for controlling the flux ratio of the precursor to the halogen radicals, as well as at least one of the temperature of the target and the temperature of the etching member, so as to perform an adsorption step of causing crystal nuclei of the precursor to be adsorbed on the etching member, and an etching step of anisotropically etching, in a thickness direction by the halogen radicals, a portion of the etching member on which the crystal nuclei have been adsorbed.

14. An etching apparatus as described in claim 13, wherein
the system composed of the halogen radical supply means and the precursor supply means comprises
a noble metal member located at a position facing the etching member in the interior of the chamber,
working gas supply means for supplying a halogen-containing working gas into the chamber, and
working gas plasma generation means for generating halogen radicals from the working gas through formation of a plasma thereof in the interior of the chamber, and for etching the noble metal member by the halogen radicals, thereby forming a precursor from the halogen and a noble metal component;
the etching apparatus further comprises etching temperature control means for respectively controlling the temperature of the noble metal member and the temperature of the etching member; and
the etching control means has a function of performing the adsorption step by controlling, through the etching temperature control means, the temperature of the etching member to a lower temperature so that crystal nuclei of the precursor are adsorbed on the etching member, as well as a function of performing the etching step by controlling, through the etching temperature control means, the temperature of the etching member to a higher temperature so that a portion of the etching member on which the crystal nuclei have been adsorbed is anisotropically etched in a thickness direction by the halogen radicals.

15. An etching apparatus as described in claim 14, wherein the etching control means has a function of changing, through the etching temperature control means, the temperature of the noble metal member to a higher temperature for increasing the size of the crystal nuclei or to a lower temperature for reducing the size of the crystal nuclei during etching of the noble metal member by the halogen radicals.

16. A thin film formation apparatus having
a chamber for accommodating an etching and film formation member;
a film-forming metal member provided in the chamber at a position facing the etching and film formation member;
working gas supply means for supplying a halogen-containing working gas into the chamber;
working gas plasma generation means for generating halogen radicals from the working gas through formation of a plasma thereof in the interior of the chamber, and for etching the film-forming metal member by the halogen radicals, thereby forming a precursor from the halogen and the metal component contained in the film-forming metal member; and
film formation temperature control means for controlling the temperature of the substrate to be lower than that of the etching member so that a thin film formed of the metal component generated through reduction of the precursor by the halogen radicals is provided on the substrate, wherein the thin film formation apparatus further comprises halogen radical supply means for supplying halogen radicals into the chamber at a position above the etching and film formation member, the halogen radicals being generated from a halogen through formation of a plasma thereof, **characterized in that** the apparatus comprises
precursor supply means for supplying a precursor into the chamber at a position above the etching and film formation member, the precursor being formed from the halogen and a noble metal component generated through etching of a noble metal member by the halogen radicals;
etching temperature control means for respectively controlling the temperature of the noble metal member, and the temperature of the etching and film formation member; and
etching control means for controlling the flux ratio of the precursor to the halogen radicals, as well as at least one of the temperature of the target and the temperature of the etching and film formation member, so as to perform an adsorption step of causing crystal nuclei of the precursor to be adsorbed on the etching and film formation member, and an etching step of anisotropically etching, in a thickness direction by the halogen radicals, a portion of the etching and film formation member on which the crystal nuclei have been adsorbed.

17. A thin film formation apparatus as described in claim 16, wherein the etching control means has a function of performing the adsorption step by controlling, through the etching temperature control means, the temperature of the etching and film formation member to a lower temperature so that crystal nuclei of the precursor are adsorbed on the etching and film formation member, as well as a function of performing the etching step by controlling, through the etching temperature control means, the temperature of the etching and film formation member to a higher temperature so that a portion of the etching and film formation member on which the crystal nuclei have been adsorbed is anisotropically etched in a thickness direction by the halogen radicals.

18. A thin film formation apparatus as described in claim 17, wherein the etching control means has a function of changing, through the etching temperature control means, the temperature of the noble metal member to a higher temperature for increasing the size of the crystal nuclei or to a lower temperature for reducing the size of the crystal nuclei during etching of the noble metal member by the halogen radicals.
